# EUROPEAN PATENT SPECIFICATION

(11) **EP 4 560 333 B1**
(45) Date of publication and mention of the grant of the patent: **25.11.2026**
(21) Application number: 23900806.3
(22) Date of filing: 17.07.2023
(51) Int. Cl.: H02J 7/80, H02J 7/64, G01R 31/3835, G01R 19/165

(54) **BATTERY PACK VOLTAGE MEASUREMENT CIRCUIT**
SPANNUNGSMESSSCHALTUNG FÜR BATTERIEPACK
CIRCUIT DE MESURE DE TENSION DE BLOC-BATTERIE

(30) Priority: 05.12.2022 KR 20220167473
(43) Date of publication of application: 28.05.2025
(73) Proprietor: LG Energy Solution, Ltd., Seoul 07335 (KR)
(72) Inventor: KIM, Kang San, Daejeon 34122 (KR)
(74) Representative: Plasseraud IP
(86) International application number: PCT/KR2023/010223
(87) International publication number: WO 2024/122784

(56) References cited:
- CN-A- 103 344 822
- CN-A- 103 344 822
- CN-U- 203 350 420
- KR-A- 20140 136 845
- KR-A- 20200 054 714
- KR-A- 20210 126 860
- KR-A- 20220 153 292
- US-A1- 2020 153 055

## Description

### TECHNICAL FIELD

The present invention relates to a battery pack voltage measurement circuit, and more particularly, to a battery pack voltage measurement circuit that measures a voltage of a battery pack and outputs a resultant value.

### BACKGROUND ART

Secondary batteries that can be charged and discharged, that is, batteries, are widely used as energy sources for mobile devices such as smart phones. In addition, batteries are also used as energy sources for eco-friendly vehicles such as electric vehicles and hybrid electric vehicles, which are proposed as a solution to air pollution caused by gasoline vehicles and diesel vehicles using fossil fuels. The types of applications using batteries are becoming very diverse, and it is expected that in the future batteries will be applied to more fields and products than now.

Such a battery is generally used in the form of a battery pack rather than being used as a single battery cell. A battery pack includes at least one battery module, and the battery module may include a plurality of battery cells. In addition, battery packs are being developed with high-capacity and high-voltage specifications to be used longer and driven more powerfully according to consumer demand.

The high-voltage specification of a battery pack provides more powerful driving power to power consuming devices such as electric vehicles using the battery pack. However, since the internal characteristics and internal resistance of battery cells constituting a battery pack are different, a voltage deviation may occur between the battery cells as a high voltage battery is continuously charged and discharged. When voltage deviations between battery cells are accumulated, the battery cells may be overcharged or overdischarged and thus cause fatal damage to a high voltage battery. In addition, when the lifespan of battery cells constituting a battery pack is reduced or the performance thereof is degraded, the performance of the battery pack may be deteriorated. Therefore, in order to monitor and manage the performance of a battery pack, it is necessary to accurately measure the voltage of the battery pack, which determines the performance of the battery pack. To this end, the battery pack includes a battery pack voltage measurement circuit.

The battery pack voltage measurement circuit includes a relay switch and an analog to digital converting (ADC) output circuit. Here, the relay switch performs an on/off operation on the basis of an overcurrent, and the ADC output circuit measures the voltage of the battery pack according to a current flowing through the relay switch.

Meanwhile, the voltage of a battery pack used in an electric vehicle tends to increase from 400 V to 800 V. Therefore, the battery pack voltage measurement circuit should also be designed suitably for the increased voltage of the battery pack. For this, the relay switch composed in the battery pack voltage measurement circuit should satisfy an allowable voltage value of 800 V. However, in the case of a relay switch that stably operates at an allowable voltage of 800 V, an advanced process technology and high-quality materials should be used, and thus a very high price relay switch, that is, a high-specification relay switch is required. When an existing low-specification relay switch having an allowable voltage value of 400 V is used to measure the voltage of a battery pack of 800 V, various problems may occur because the off point of the relay switch may be delayed.

In order to use a low-specification relay switch, a battery pack voltage measurement circuit may be configured by connecting a low-specification relay switch and relay resistor in parallel. That is, a battery pack voltage measurement circuit may be configured in a manner in which a first resistor, a relay circuit, a second resistor, and an ADC output circuit are connected in series between a ground terminal and a power terminal of the battery pack and the relay circuit is provided with a relay element and relay resistor connected in parallel. Such a battery pack voltage measurement circuit has the advantage of enabling to use a 400 V rated relay switch even in an 800 V battery pack by adding a relay resistor in parallel with a relay switch. However, there is a problem in that a leakage current occurs through the relay resistor even after the relay switch is turned off. In addition, since first and second resistors are set to a resistance ratio of 800 V, measurement accuracy is degraded when measuring a battery pack voltage of 400 V having a resistance ratio higher than this.

Prior art related to this includes the following documents: KR2014/136845, US-A-2020/153055.

### DISCLOSURE OF THE INVENTION

### TECHNICAL PROBLEM

The present invention provides a battery pack voltage measurement circuit capable of measuring a high voltage by using a low-specification relay switch.

The present invention provides a battery pack voltage measurement circuit capable of preventing a leakage current even when using a low-specification relay switch.

### TECHNICAL SOLUTION

A battery pack voltage measurement circuit according to an example of the present invention is defined by the independent claim 1 and, among others, includes: : a relay unit performing battery pack voltage measurement; first and second branching units provided between a battery pack voltage input terminal and the relay unit, and branching a battery pack voltage into different paths according to the battery pack voltage and then supplying the branched voltage to the relay unit; and a voltage distribution unit dividing the battery pack voltage supplied through the first or second branching unit and the relay unit and outputting the divided battery pack voltage to an output terminal.

The first branching unit may include a second resistor and a first switch connected in series between the battery pack voltage input terminal and the relay unit.

The second branching unit may include a third resistor and a second switch connected in series between the battery pack voltage input terminal and the relay unit and connected in parallel with the second resistor and the first switch, respectively.

The relay unit includes a relay switch and a third resistor connected in parallel between a connection point of the first and second branching units and the voltage distribution unit.

The battery pack voltage measurement circuit may further include a control unit for controlling the second switch, the third switch, and the relay switch.

The control unit may selectively open and close the second and third switches according to the magnitude of the battery pack voltage.

A first resistance ratio, which is a ratio between the sum of resistors of the voltage distribution unit and the first resistor, and a second resistance ratio, which is a ratio between the sum of resistors of the voltage distribution unit and the second resistor, may be set to be different from each other.

### ADVANTAGEOUS EFFECTS

It is possible to mass-produce a battery pack voltage measurement circuit according to an embodiment of the present invention at a lower manufacturing cost because it is possible to use a relay switch with a low specification. That is, the present invention has an effect applicable to a voltage of 800 V with a relay rated at, for example, 400 V since by connecting a relay resistor in parallel with a relay switch, only a low level battery pack voltage, which is a part of a battery pack voltage, is applied even when the relay switch is turned off due to the relay resistor.

In addition, in the present invention, since a battery pack voltage is branched through first and second branching units, it is possible to measure two different battery pack voltages. That is, since a battery pack voltage of 400 V is branched through the first branching unit and a battery pack voltage of 800 V is branched through the second branching unit, it is possible to measure the battery pack voltage of 400 V or 800 V by using one battery pack voltage measurement circuit. Therefore, it is possible to use one battery pack voltage measurement circuit for a system to which a 400 V battery pack is applied and a system to which an 800 V battery pack is applied, and accordingly, there is no need to develop different battery pack voltage measurement circuits, thereby reducing product development costs and the like.

In addition, since it is possible to control a battery pack voltage measurement circuit by first and second switches of the first and second branching units of the present invention, it is possible to prevent occurrence of a leakage current due to a relay resistor even when a relay switch is turned off. That is, assuming that there are no first and second switches, a leakage current may occur through a relay resistor when a relay switch is turned off, but when the relay switch is turned off, first and second switches also remain off, so that it is possible to prevent occurrence of a leakage current.

### BRIEF DESCRIPTION OF THE DRAWINGS

FIG. 1 is a circuit diagram of a battery pack voltage measurement circuit according to an embodiment of the present invention.
FIGS. 2 to 4 are circuit diagrams showing a current flow to explain a driving method of a battery pack voltage measurement circuit according to an embodiment of the present invention.

### MODE FOR CARRYING OUT THE INVENTION

Hereinafter, embodiments of the present invention will be described in detail with reference to the accompanying drawings. However, the present invention is not limited to the embodiments disclosed below, but will be implemented in various different forms, and these embodiments are provided merely to make the disclosure of the present invention complete, and to allow those skilled in the art to fully know the scope of the invention.

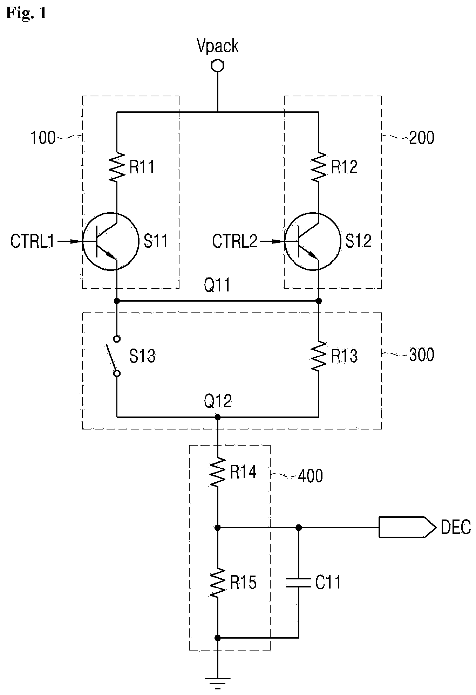

FIG. 1 is a circuit diagram of a battery pack voltage measurement circuit according to an embodiment of the present invention.

Referring to FIG. 1, a battery pack voltage measurement circuit according to an embodiment of the present invention includes a first branching unit 100, a second branching unit 200, a relay unit 300, and a voltage distribution unit 400 connected between a battery pack voltage input terminal, that is, a power terminal Vpack and a ground terminal GND. More specifically, the battery pack voltage measurement circuit according to an embodiment of the present invention includes first and second branching units 100 and 200 connected in parallel between a power terminal Vpack and a first node Q11, a relay unit 300 connected between the first node Q11 and a second node Q12, and a voltage distribution unit 400 connected between the second node Q12 and a ground terminal GND. Here, the first and second branching units 100 and 200 set a path of a current input from the power terminal Vpack to first and second paths. In addition, the relay unit 300 includes a relay switch S13 and a relay resistor, that is, a third resistor R13 connected in parallel, and the measurement of a battery pack voltage is performed and stopped by an on/off operation of a relay switch S13. Moreover, the voltage distribution unit 400 divides and outputs a voltage of a current input through the first path or the second path in order to measure a voltage output to an output terminal DEC. The battery pack voltage measurement circuit according to the embodiment of the present invention will be described in more detail for each component as follows.

### 1. First branching unit

The first branching unit 100 is connected between the power terminal Vpack and the first node Q11, and is connected in parallel with the second branching unit 200. The first branching unit 100 may include a first resistor R11 and a first switch S11 connected in series between the power terminal Vpack and the first node Q11. That is, the first resistor R11 and the first switch S11 are connected in series between the power terminal Vpack and the first node Q11 to form the first branching unit 100. The first branching unit 100 sets a current to flow in the first path through the first branching unit 100 according to a battery pack voltage. That is, when a first current according to a first voltage is applied from the power terminal Vpack, the first branching unit 100 is driven so that a current flows in the first path through the first branching unit 100. Here, the first voltage of the battery pack may be 400 V. That is, when the battery pack voltage is 400 V, a current flows through the first branching unit 100.

The first switch S11 may be an FET driven according to a first control signal CTRL1 of a control unit (not shown). When the battery pack voltage is the first voltage, that is, 400 V, the control unit generates the first control signal CTRL1, and accordingly, the first switch S11 is driven so that a current flows through the first branching unit 100. For example, when the battery pack voltage is 400 V, the first control signal CTRL1 is output at a logic high level to drive the first switch S11. Of course, when the battery pack voltage is a second voltage higher than the first voltage, the first control signal CTRL1 is not generated, and thus the first switch S11 is turned off. For example, when the battery pack voltage is 800 V, the first control signal CTRL1 is output at a logic low level to turn off the first switch S11. In addition, the first branching unit 100 drops down the battery pack voltage and supplies the voltage to the relay unit 300. That is, the first branching unit 100 drops the battery pack voltage of 400 V by the first resistor R11 and supplies the voltage to the relay unit 300. Therefore, even when the battery pack voltage of 400 V is applied to the power terminal Vpack, the voltage dropped by the first resistor R11 is applied to the relay unit 300.

Meanwhile, the battery pack voltage measurement circuit of the present invention supplies a voltage of 400V to the voltage distribution unit 400 through the first branching unit 100, and outputs the voltage after dividing the voltage by 100:1, for example. Accordingly, the first resistor R11 may have a resistance value of a predetermined ratio with fourth and fifth resistors R14 and R15 of the voltage distribution unit 400. For example, if the fourth resistor R14 is 1 MΩ and the fifth resistor R15 is 20 KΩ, the first resistor R11 may have a resistance value of 1 MΩ. In this way, the first resistor R11 has a resistance value of a predetermined ratio with the fourth and fifth resistors R14 and R15, so that the voltage of 400 V through the first branching unit 100 may be divided by 100:1 and output to the output terminal DEC.

### 2. Second branching unit

The second branching unit 200 is connected between the power supply terminal Vpack and the first node Q11, and is connected in parallel with the first branching unit 100. The second branching unit 200 may include a second resistor R12 and a second switch S12 connected in series between the power supply terminal Vpack and the first node Q11. That is, the second resistor R12 and the second switch S12 are connected in series between the power terminal Vpack and the first node Q11 to form the second branching unit 200. The second branching unit 200 sets a current to flow in the second path through the second branching unit 200 according to a battery pack voltage. That is, when a second current according to the second voltage is applied from the power terminal Vpack, the second branching unit 200 is driven so that a current flows in the second path through the second branching unit 200. Here, the second voltage of the battery pack may be 800 V. That is, when the battery pack voltage is 800V, a current flows through the second branching unit 200.

The second switch S12 may be an FET driven according to a second control signal CTRL2 of a control unit (not shown). When the battery pack voltage is the second voltage, that is, 800 V, the control unit generates a second control signal CTRL2, and accordingly, the second switch S12 is driven so that a current flows through the second branching unit 200. For example, when the battery pack voltage is 800 V, the second control signal CTRL2 is output at a logic high level to drive the second switch S12. Of course, when the battery pack voltage is the first voltage lower than the second voltage, the second control signal CTRL2 is not generated, and thus the second switch S12 is turned off. For example, when the battery pack voltage is 400 V, the second control signal CTRL2 is output at a logic low level to turn off the second switch S12. In addition, the second branching unit 200 drops the battery pack voltage and supplies the voltage to the relay unit 300. That is, the second branching unit 200 drops the battery pack voltage of 800 V by the second resistor R12 and supplies the voltage to the relay unit 300. Therefore, even when the battery pack voltage of 800 V is applied to the power terminal Vpack, the voltage dropped by the second resistor R12 is applied to the relay unit 300.

Meanwhile, the battery pack voltage measurement circuit of the present invention supplies 800 V voltage to the voltage distribution unit 400 through the second branching unit 200, and outputs the voltage after dividing the voltage by 200:1. Accordingly, the second resistor R12 may have a resistance value of a predetermined ratio with the fourth and fifth resistors R14 and R15 of the voltage distribution unit 400. For example, if the fourth resistor R14 is 1 MΩ and the fifth resistor R15 is 20 KΩ, the second resistor R12 may have a resistance value of 3 MΩ. In this way, the first resistor R11 has a resistance value of a predetermined ratio with the fourth and fifth resistors R14 and R15, so that the voltage of 800 V through the second branching unit 200 may be divided by 200:1 and output to the output terminal DEC.

### 3. Relay unit

The relay unit 300 is connected between the first node Q11 and the second node Q12. That is, the relay unit 300 is provided between the first and second branching units 100 and 200 and the voltage distribution unit 400 connected in parallel. The relay unit 300 may include a third switch, that is, the relay switch S13 and a third resistor, that is, the relay resistor R13. At this time, the relay switch S13 and the relay resistor R13 are connected in parallel between the first node Q11 and the second node Q13. The relay switch S13 is driven by a control signal (not shown) for measuring a battery pack voltage and provides a voltage through the first branching unit 100 or the second branching unit 200 to the voltage distribution unit 400. That is, when a control signal (not shown) is generated to measure a battery pack voltage and applied to the relay switch S13, the relay switch S13 is turned on to provide a voltage through the first branching unit 100 or the second branching unit 200 to the voltage distribution unit 400.

The relay switch S13 is not shown in detail in the drawings, but may be composed of a solenoid and a switch. An on/off operation of the relay switch S13 may be controlled on the basis of a magnetic force generated in the solenoid. In addition, the relay resistor R13 is connected in parallel with the relay switch S13, so that when the relay switch S13 is turned off, a voltage applied to opposite ends of the relay switch S13 is the same as a voltage applied to opposite ends of the relay resistor R13.

Meanwhile, in the case of the prior art without the relay resistor R13, when the relay switch S13 is turned off, most of a battery pack voltage is applied to opposite ends of the relay switch S13, so that a higher rated relay may be required if the battery pack voltage is a high voltage of 800 V, for example. However, the present invention has an effect applicable to a voltage of 800 V with a relay rated at, for example, 400 V since by connecting the relay resistor R13 in parallel with the relay switch S13, only a low level battery pack voltage, which is a part of a battery pack voltage, is applied even when the relay switch S13 is turned off due to the relay resistor R13. That is, since a voltage dropped by the first branching unit 100 or the second branching unit 200 is applied to one side of the relay switch S13, the relay switch S13 may be designed as a low-end relay element. Moreover, since a voltage dropped by the first branching unit 100 or the second branching unit 200 and the relay resistor R13 is applied to the other side of the relay switch S13, a stable on/off operation may be guaranteed even when the relay switch S13 is used as a low-specification relay switch.

In addition, since it is possible to control the battery pack voltage measurement circuit by the first and second switches S11 and S12 of the first and second branching units 100 and 200 of the present invention, it is possible to prevent occurrence of a leakage current due to the relay resistor R13 even when the relay switch S13 is turned off. That is, assuming that there are no first and second switches S11 and S12, a leakage current may occur through the relay resistor R13 when the relay switch S13 is turned off, but when the relay switch S13 is turned off, the first and second switches S11 and S12 also remain off, so that it is possible to prevent occurrence of a leakage current due to the resistor R13.

Meanwhile, a resistance value of the relay resistor R13 may be determined to satisfy Equation 1 below. [Equation 1] $\frac{R 13}{\left(R12+R13+R14\right)} \times {V}_{0} < {V}_{lim}$

Equation 1 is an equation excluding an ADC output circuit, that is, the fifth resistor R15. Here, R12, R13, and R14 are respectively resistance values of the second resistor R12, the relay resistor R13, and the fourth resistor R14, Vₗᵢₘ is an allowable voltage value of the relay switch S13, and Vo means a voltage of a battery pack. In addition, since the second resistor R12 of the second branching unit 200 is greater than the first resistor R11 of the first branching unit 100, a resistance value of the relay resistor R13 in Equation 1 is affected by a resistance value of the second resistor R12.

As shown in Equation 1, an allowable voltage value Vₗᵢₘ of a relay switch S13 should be smaller than a voltage value Vo of a battery pack. At this time, the voltage value Vo of the battery pack is reduced by respective resistance values of the second resistor R12, the relay resistor R13, and the fourth resistor R14. Therefore, even when the voltage value Vo of the battery pack increases, for example, from 400 V to 800 V, the allowable voltage value Vₗᵢₘ of the relay switch S13 may be satisfied if the resistance values of the second resistor R12, relay resistor R13, and fourth resistor R14 are appropriately designed. Here, even when the voltage value Vo of the battery pack is 800 V, the fact that the allowable voltage value Vₗᵢₘ of the relay switch S13 is satisfied means that even when the relay switch S13 of low specification is used, it is possible to stably measure the voltage Vo of the battery pack having a high voltage. In addition, when the relay switch S13 is turned off, a voltage dropped by the first resistor or the second resistor R11 or R12 is applied to one end of the relay switch S13, and a voltage which is the same as a voltage applied to opposite ends of the relay resistor R13 is applied to opposite ends of the relay switch S13. Therefore, even when the relay switch S13 is used with a low specification, it is possible to stably perform an off operation of the relay switch S13.

As described above, through these configurations and operations, the battery pack voltage measurement circuit according to an embodiment of the present invention provides an environment in which it is possible to use the relay switch S13 with a low specification.

Meanwhile, a resistance value of the relay resistor R13 is determined to satisfy Equation 2 below. [Equation 2] $\frac{R 13}{\left(R12+R13+R14+R15\right)} \times {V}_{0} < {V}_{lim}$

Equation 2 is an equation including an ADC output circuit, that is, the fifth resistor R13. Here, R12, R13, R14, and R15 are respectively resistance values of the second resistor R12, the relay resistor R13, the fourth resistor R14, and the fifth resistor R15, Vₗᵢₘ is an allowable voltage value of the relay switch S13, and Vo means a voltage of a battery pack.

Equation 2, like Equation 1, the allowable voltage value Vₗᵢₘ of the relay switch S13 may be smaller than the voltage value Vo of the battery pack, and the voltage value Vo of the battery pack is applied with a voltage drop by resistance values of the second resistor R12, the relay resistor R13, the fourth resistor R14, and the fifth resistor R15. In particular, in Equation 2, the voltage value (Vo) of the battery pack may be controlled to be lower by the resistance value of the fifth resistor R15, which means that even when becoming higher, the voltage value (Vo) of the battery pack may be included in the allowable voltage value (Vₗᵢₘ) of the relay switch S13.

As described above, since in the battery pack voltage measurement circuit according to the embodiment of the present invention, it is possible to use the relay switch S13 with a low specification, it is possible to mass-produce the battery pack voltage measurement circuit at a lower manufacturing cost. In addition, since it is possible to control the battery pack voltage measurement circuit by the first and second switches S11 and S12 of the first and second branching units 100 and 200 of the present invention, it is possible to prevent occurrence of a leakage current due to the relay resistor R13 even when the relay switch S13 is turned off. That is, when the relay switch S13 is turned off, the first and second switches S11 and S12 also remain off, so that it is possible to prevent occurrence of a leakage current due to the relay resistor R13.

### 4. Voltage distribution unit

The voltage distribution unit 400 is connected between the second node Q12 and the ground terminal GND. The voltage distribution unit 400 divides and outputs a voltage of a current input through the first path or the second path to measure a voltage output to the output terminal DEC. That is, the voltage distribution unit 400 divides a battery pack voltage Vpack supplied through the first branching unit 100 and the relay unit 300 and outputs the voltage to the output terminal DEC, and divides a battery pack voltage Vpack supplied through the second branching unit 200 and the relay unit 300 and outputs the voltage to the output terminal DEC. At this time, the battery pack voltage supplied through the first branching unit 100 is 400 V, and the battery pack voltage supplied through the second branching unit 200 is 800 V. That is, the voltage distribution unit 400 divides the battery pack voltage of 400V or 800V and outputs the voltage to the output terminal DEC.

The voltage distribution unit 400 may include the fourth and fifth resistors R14 and R15 connected in series between the second node Q12 and the ground terminal GND. At this time, the output terminal DEC is provided between the fourth and fifth resistors 14 and 15. That is, the fourth resistor R14 is connected between the second node Q12 and the output terminal DEC, and the fifth resistor R15 is connected between the output terminal DEC and the ground terminal GND to form the voltage distribution unit 400. Accordingly, the voltage distribution unit 400 divides the battery pack voltage through the fourth and fifth resistors R14 and R15 and outputs the voltage to the output terminal DEC. Meanwhile, a capacitor C11 connected in parallel with the fifth resistor R15 is provided at the output terminal DEC. Meanwhile, the fourth and fifth resistors R14 and R15 may have predetermined resistance values. That is, the fourth and fifth resistors R14 and R15 may have resistance values having a predetermined ratio with resistance values of the first and second resistors R11 and R12. For example, the fourth resistor R14 may have a resistance value of 1 MΩ, and the fifth resistor R15 may have a resistance value of 20 KΩ. At this time, the first resistor R11 may have a resistance value of, for example, 1 MΩ, and the second resistor R12 may have a resistance value of, for example, 3 MΩ. In this way, the fourth and fifth resistors have a resistance value of a predetermined ratio with the first and second resistors R11 and R12, respectively, so that the voltage of 400 V through the first branching unit 100 may be divided by 100:1 and the voltage of 800 V through the second branching unit 200 may be divided to be output to the output terminal DEC.

As described above, since in the battery pack voltage measurement circuit according to the embodiment of the present invention, it is possible to use the relay switch S13 with a low specification, it is possible to mass-produce the battery pack voltage measurement circuit at a lower manufacturing cost. That is, the present invention has an effect applicable to a voltage of 800 V with a relay rated at, for example, 400 V since by connecting the relay resistor R13 in parallel with the relay switch S13, only a low level battery pack voltage, which is a part of a battery pack voltage, is applied even when the relay switch S13 is turned off due to the relay resistor R13. In addition, since it is possible to control the battery pack voltage measurement circuit by the first and second switches S11 and S12 of the first and second branching units 100 and 200 of the present invention, it is possible to prevent occurrence of a leakage current due to the relay resistor R13 even when the relay switch S13 is turned off. That is, assuming that there are no first and second switches S11 and S12, a leakage current may occur through the relay resistor R13 when the relay switch S13 is turned off, but when the relay switch S13 is turned off, the first and second switches S11 and S12 also remain off, so that it is possible to prevent occurrence of a leakage current due to the resistor R13. In addition, in the present invention, since a battery pack voltage is branched through the first and second branching units 100 and 200, it is possible to measure two different battery pack voltages. That is, since a battery pack voltage of 400 V is branched through the first branching unit 100 and a battery pack voltage of 800 V is branched through the second branching unit 200, it is possible to measure the battery pack voltage of 400 V or 800 V by using one battery pack voltage measurement circuit. Therefore, it is possible to use one battery pack voltage measurement circuit for a system to which a 400 V battery pack is applied and a system to which an 800 V battery pack is applied, and accordingly, there is no need to develop different battery pack voltage measurement circuits, thereby reducing product development costs and the like.

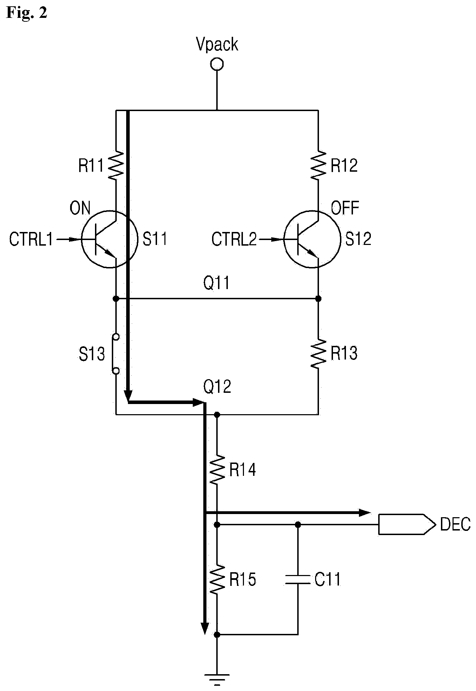

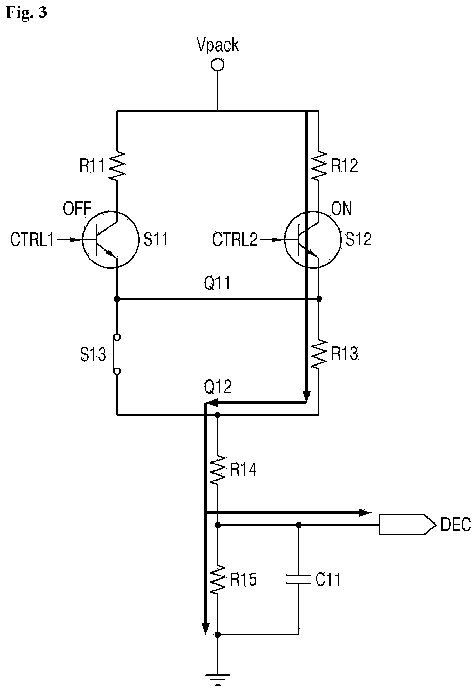

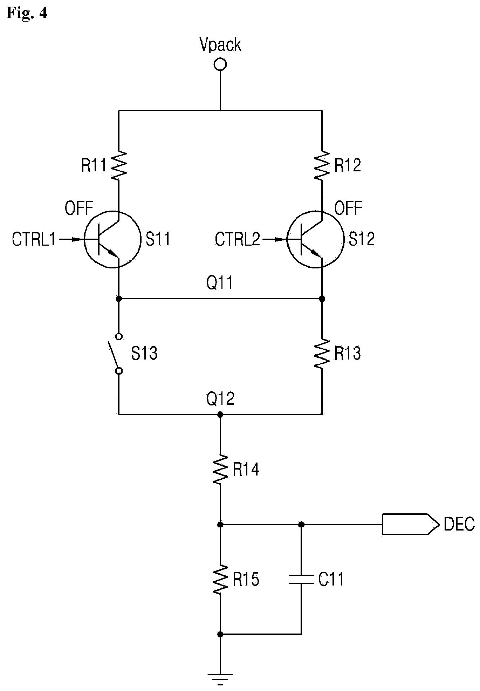

FIGS. 2 to 4 are circuit diagrams showing a current flow to explain a driving method of a battery pack voltage measurement circuit according to an embodiment of the present invention. That is, FIG. 2 is a circuit diagram showing a current flow when a battery pack voltage is 400 V, FIG. 3 is a circuit diagram showing a current flow when a battery pack voltage is 800 V, and FIG. 4 is a circuit diagram for explaining a driving method when switches are turned off.

Referring to FIG. 2, a relay switch S13 may be turned on by a predetermined control signal to measure a battery pack voltage. At this time, a control unit (not shown) may output a first control signal CTRL1 or a second control signal CTRL2 according to a battery pack voltage, and when the battery pack voltage is, for example, 400 V, the first control signal CTRL1 may be output at a high level and the second control signal CTRL2 may be output at a low level. When a first switch S11 is turned on by the high-level first control signal CTRL1, a current according to the battery pack voltage flows through a first path, that is, a first branching unit 100. That is, when the first control signal is applied at a high level, the battery pack voltage of 400 V is supplied to a relay unit 300 through the first path and then supplied to a voltage distribution unit 400. At this time, a voltage drop occurs through the first branching unit 100 and the relay unit 300, and the voltage distribution unit 400 divides the dropped battery pack voltage and outputs the voltage to an output terminal DEC. Meanwhile, a first resistor R11, a fourth resistor R14, and a fifth resistor R15 have predetermined resistance values, and accordingly, the battery pack voltage is dropped by, for example, 100:1 and output to the output terminal DEC. In order to drop the battery pack voltage of 400 V by about 100:1 and output the voltage, the first, fourth, and fifth resistors R11, R14, and R15 may have resistance values of 1 MΩ, 1 MΩ, and 20 KΩ, respectively. Eventually, the battery pack voltage of 400 V may be dropped and divided through the first branching unit 100, the relay unit 300, and the voltage distribution unit 400 and output to the output terminal DEC, and an output value of the output terminal DEC may be input to an analog to digital converter of a control unit (not shown), that is, an MCU.

Referring to FIG. 3, the relay switch S13 may be turned on by a predetermined control signal to measure the battery pack voltage. At this time, a control unit (not shown) may output the first control signal CTRL1 or the second control signal CTRL2 according to the battery pack voltage, and when the battery pack voltage is, for example, 800 V, the second control signal CTRL2 may be output at a high level and the first control signal CTRL1 may be output at a low level. When a second switch S12 is turned on by the second control signal CTRL2 at a high level, a current according to the battery pack voltage flows through a second path, that is, a second branching unit 200. That is, when the second control signal is applied at a high level, the battery pack voltage of 800 V is supplied to the relay unit 300 through the second path and then supplied to the voltage distribution unit 400. At this time, a voltage drop occurs through the second branching unit 200 and the relay unit 300, and the voltage distribution unit 400 divides the dropped battery pack voltage and outputs the voltage to the output terminal DEC. Meanwhile, a second resistor R12, the fourth resistor R14, and the fifth resistor R15 have predetermined resistance values, and accordingly, the battery pack voltage is dropped by, for example, 200:2 and output to the output terminal DEC. In order to drop the battery pack voltage of 800 V by about 200:1 and output the voltage, the second, fourth, and fifth resistors R12, R14, and R15 may have resistance values of 3 MΩ, 1 MΩ, and 20 KΩ, respectively. Eventually, the battery pack voltage of 800 V may be dropped and divided through the second branching unit 200, the relay unit 300, and the voltage distribution unit 400 and output to the output terminal DEC, and an output value of the output terminal DEC may be input to an analog to digital converter of a control unit (not shown), that is, an MCU.

Referring to FIG. 4, when the battery pack voltage is not measured, the relay switch S13 may be turned off by a predetermined control signal. At this time, in a control unit (not shown), the first and second control signals CTRL1 and CTRL2 may be output in a low state as the relay switch S13 is turned off. Accordingly, the first and second switches S11 and S12 may be turned off. As the relay switch S13 and the first and second switches S11 and S12 are all turned off, it is possible to prevent a leakage current due to the relay resistor R13. That is, assuming that there are no first and second switches S11 and S12, a leakage current may occur through the relay resistor R13 when the relay switch S13 is turned off, but when the relay switch S13 is turned off, the first and second switches S11 and S12 also remain off, so that it is possible to prevent occurrence of a leakage current due to the resistor R13.

Although the present invention as described above has been specifically described according to the above embodiments, it should be noted that the above embodiments are for explanation and not for limitation.

The names of the reference numerals used in the description and drawings of the present invention are as follows.

| | | | |
|---|---|---|---|
| 100 : | First branching unit | 200 : | Second branching unit |
| 300 : | Relay unit | 400 : | Voltage distribution unit |

## Claims

1. A battery pack voltage measurement circuit, comprising:
a relay unit (300) configured to control battery pack voltage measurement;
first and second branching units (100, 200) provided between a battery pack voltage input terminal and the relay unit (300) , and configured to branch a battery pack voltage into different paths according to the battery pack voltage and then to supply the branched voltage to the relay unit (300);
a voltage distribution unit (400) configured to divide the battery pack voltage supplied through the first or second branching unit (100, 200) and the relay unit (300) and to output the divided battery pack voltage to an output terminal, terminal (DEC), and wherein the relay unit (300) comprises a relay switch (S13) and a first resistor (R13) connected in parallel between a connection point (Q11) of the first and second branching units and the voltage distribution unit (400).

2. The battery pack voltage measurement circuit of claim 1, wherein the first branching unit (100) comprises a second resistor (R11) and a first switch (S11) connected in series between the battery pack voltage input terminal and the relay unit (300).

3. The battery pack voltage measurement circuit of claim 2, wherein the second branching unit (200) comprises a third resistor (R12) and a second switch (S12) connected in series between the battery pack voltage input terminal and the relay unit (300) and connected in parallel with the second resistor (R11) and the first switch (S11), respectively.

4. The battery pack voltage measurement circuit of claim 3, further comprising a control unit for controlling the second switch (S11), the third switch (S12), and the relay switch (S13).

5. The battery pack voltage measurement circuit of claim 4, wherein the control unit is configured to selectively open and close the second switch (S11) and the third switch (S12) according to a magnitude of the battery pack voltage.

6. The battery pack voltage measurement circuit of claim 3, configured such that a first resistance ratio, which is a ratio between the sum of resistors of the voltage distribution unit (400) and the first resistor (R11), and a second resistance ratio, which is a ratio between the sum of resistors of the voltage distribution unit (400) and the second resistor (R12), are set to be different from each other.

7. The battery pack voltage measurement circuit of claim 1, wherein
the first branching unit (100) is provided between the battery pack voltage input terminal and a first node (Q11) to branch the first battery pack voltage;
the second branching unit (200) is provided between the battery pack voltage input terminal and the first node (Q11) and connected in parallel with the first branching unit (100) to branch a second battery pack voltage;
the relay unit (300) is disposed between the first node (Q11) and a second node (Q12) and is configured to control measurement of the battery pack voltage according to a switching operation; and
the voltage distribution unit (400) is provided between the second node (Q12) and the ground terminal, and is configured to divide a battery pack voltage supplied through the first (100) or second branching unit (200) and the relay unit (300) and then to output the voltage to an output terminal.

8. The battery pack voltage measurement circuit of claim 7, wherein the first branching unit (100) comprises a second resistor (R11) and a first switch (S11) connected in series between the battery pack voltage input terminal and the first node (Q11).

9. The battery pack voltage measurement circuit of claim 8, wherein the second branching unit (200) comprises a third resistor (R12) and a second switch (S12) connected in series between the battery pack voltage input terminal and the first node (Q11) and connected in parallel with the second resistor (R11) and the first switch (S11), respectively.

10. The battery pack voltage measurement circuit of claim 9, wherein the relay switch (S13) and a first resistor (R13) are connected in parallel between the first node (Q11) and the second node (Q12).

11. The battery pack voltage measurement circuit of claim 10, wherein resistance values of the first resistor (R11) and the second resistor (R12) are different from each other.

## Patentansprüche

1. Batteriepack-Spannungsmessschaltung, umfassend:
• eine Relaiseinheit (300), die dazu konfiguriert ist, eine Batteriepack-Spannungsmessung zu steuern;
• eine erste und eine zweite Verzweigungseinheit (100, 200), die zwischen einem Batteriepack-Spannungseingangsanschluss und der Relaiseinheit (300) vorgesehen sind und dazu konfiguriert sind, eine Batteriepack-Spannung in verschiedene Pfade gemäß der Batteriepack-Spannung zu verzweigen und dann die verzweigte Spannung an die Relaiseinheit (300) zu liefern;
• eine Spannungsverteilungseinheit (400), die dazu konfiguriert ist, die durch die erste oder die zweite Verzweigungseinheit (100, 200) und die Relaiseinheit (300) gelieferte Batteriepack-Spannung zu teilen und die geteilte Batteriepack-Spannung an einen Ausgangsanschluss, Anschluss (DEC), auszugeben, und
• wobei die Relaiseinheit (300) einen Relaisschalter (S13) und einen ersten Widerstand (R13) umfasst, die parallel zwischen einem Verbindungspunkt (Q11) der ersten und der zweiten Verzweigungseinheit und der Spannungsverteilungseinheit (400) geschaltet sind.

2. Batteriepack-Spannungsmessschaltung nach Anspruch 1, wobei die erste Verzweigungseinheit (100) einen zweiten Widerstand (R11) und einen ersten Schalter (S11) umfasst, die zwischen dem Batteriepack-Spannungseingangsanschluss und der Relaiseinheit (300) in Reihe geschaltet sind.

3. Batteriepack-Spannungsmessschaltung nach Anspruch 2, wobei die zweite Verzweigungseinheit (200) einen dritten Widerstand (R12) und einen zweiten Schalter (S12) umfasst, die zwischen dem Batteriepack-Spannungseingangsanschluss und der Relaiseinheit (300) in Reihe geschaltet sind und parallel mit dem zweiten Widerstand (R11) beziehungsweise dem ersten Schalter (S11) geschaltet sind.

4. Batteriepack-Spannungsmessschaltung nach Anspruch 3, ferner umfassend eine Steuereinheit zum Steuern des zweiten Schalters (S11), des dritten Schalters (S12) und des Relaisschalters (S13).

5. Batteriepack-Spannungsmessschaltung nach Anspruch 4, wobei die Steuereinheit dazu konfiguriert ist, den zweiten Schalter (S11) und den dritten Schalter (S12) gemäß einer Größe der Batteriepack-Spannung selektiv zu öffnen und zu schließen.

6. Batteriepack-Spannungsmessschaltung nach Anspruch 3, derart konfiguriert, dass ein erstes Widerstandsverhältnis, das ein Verhältnis zwischen der Summe der Widerstände der Spannungsverteilungseinheit (400) und dem ersten Widerstand (R11) ist, und ein zweites Widerstandsverhältnis, das ein Verhältnis zwischen der Summe der Widerstände der Spannungsverteilungseinheit (400) und dem zweiten Widerstand (R12) ist, so eingestellt sind, dass sie sich voneinander unterscheiden.

7. Batteriepack-Spannungsmessschaltung nach Anspruch 1, wobei
• die erste Verzweigungseinheit (100) zwischen dem Batteriepack-Spannungseingangsanschluss und einem ersten Knoten (Q11) vorgesehen ist, um die erste Batteriepack-Spannung zu verzweigen;
• die zweite Verzweigungseinheit (200) zwischen dem Batteriepack-Spannungseingangsanschluss und dem ersten Knoten (Q11) vorgesehen ist und parallel mit der ersten Verzweigungseinheit (100) geschaltet ist, um eine zweite Batteriepack-Spannung zu verzweigen;
• die Relaiseinheit (300) zwischen dem ersten Knoten (Q11) und einem zweiten Knoten (Q12) angeordnet ist und dazu konfiguriert ist, eine Messung des Batteriepack-Spannung gemäß einem Schaltvorgang zu steuern; und
• die Spannungsverteilungseinheit (400) zwischen dem zweiten Knoten (Q12) und dem Masseanschluss vorgesehen ist und dazu konfiguriert ist, eine durch die erste (100) oder die zweite Verzweigungseinheit (200) und die Relaiseinheit (300) gelieferte Batteriepack-Spannung zu teilen und dann die Spannung an einen Ausgangsanschluss auszugeben.

8. Batteriepack-Spannungsmessschaltung nach Anspruch 7, wobei die erste Verzweigungseinheit (100) einen zweiten Widerstand (R11) und einen ersten Schalter (S11) umfasst, die zwischen dem Batteriepack-Spannungseingangsanschluss und dem ersten Knoten (Q11) in Reihe geschaltet sind.

9. Batteriepack-Spannungsmessschaltung nach Anspruch 8, wobei die zweite Verzweigungseinheit (200) einen dritten Widerstand (R12) und einen zweiten Schalter (S12) umfasst, die zwischen dem Batteriepack-Spannungseingangsanschluss und dem ersten Knoten (Q11) in Reihe geschaltet sind und parallel mit dem zweiten Widerstand (R11) beziehungsweise dem ersten Schalter (S11) geschaltet sind.

10. Batteriepack-Spannungsmessschaltung nach Anspruch 9, wobei der Relaisschalter (S13) und ein erster Widerstand (R13) zwischen dem ersten Knoten (Q11) und dem zweiten Knoten (Q12) parallel geschaltet sind.

11. Batteriepack-Spannungsmessschaltung nach Anspruch 10, wobei die Widerstandswerte des ersten Widerstands (R11) und des zweiten Widerstands (R12) voneinander verschieden sind.

## Revendications

1. Circuit de mesure de tension de bloc-batterie, comprenant :
• une unité de relais (300) configurée pour commander une mesure de tension de bloc-batterie ;
• des première et deuxième unités de dérivation (100, 200) disposées entre une borne d'entrée de tension de bloc-batterie et l'unité de relais (300), et configurées pour dériver une tension de bloc-batterie en différents trajets selon la tension de bloc-batterie et ensuite pour fournir la tension dérivée à l'unité de relais (300) ;
• une unité de distribution de tension (400) configurée pour diviser la tension de bloc-batterie fournie par le biais de la première ou de la deuxième unité de dérivation (100, 200) et de l'unité de relais (300) et pour délivrer en sortie la tension de bloc-batterie divisée à une borne de sortie, borne (DEC), et
• dans lequel l'unité de relais (300) comprend un commutateur de relais (S13) et une première résistance (R13) connectés en parallèle entre un point de connexion (Q11) des première et deuxième unités de dérivation et l'unité de distribution de tension (400).

2. Circuit de mesure de tension de bloc-batterie selon la revendication 1, dans lequel la première unité de dérivation (100) comprend une deuxième résistance (R11) et un premier commutateur (S11) connectés en série entre la borne d'entrée de tension de bloc-batterie et l'unité de relais (300).

3. Circuit de mesure de tension de bloc-batterie selon la revendication 2, dans lequel la deuxième unité de dérivation (200) comprend une troisième résistance (R12) et un deuxième commutateur (S12) connectés en série entre la borne d'entrée de tension de bloc-batterie et l'unité de relais (300) et connectés en parallèle avec la deuxième résistance (R11) et le premier commutateur (S11), respectivement.

4. Circuit de mesure de tension de bloc-batterie selon la revendication 3, comprenant en outre une unité de commande pour commander le deuxième commutateur (S11), le troisième commutateur (S12) et le commutateur de relais (S13).

5. Circuit de mesure de tension de bloc-batterie selon la revendication 4, dans lequel l'unité de commande est configurée pour ouvrir et fermer de manière sélective le deuxième commutateur (S11) et le troisième commutateur (S12) selon une grandeur de la tension de bloc-batterie.

6. Circuit de mesure de tension de bloc-batterie selon la revendication 3, configuré de telle sorte qu'un premier rapport de résistance, qui est un rapport entre la somme de résistances de l'unité de distribution de tension (400) et la première résistance (R11), et un deuxième rapport de résistance, qui est un rapport entre la somme de résistances de l'unité de distribution de tension (400) et la deuxième résistance (R12), soient définis pour être différents l'un de l'autre.

7. Circuit de mesure de tension de bloc-batterie selon la revendication 1, dans lequel :
• la première unité de dérivation (100) est disposée entre la borne d'entrée de tension de bloc-batterie et un premier nœud (Q11) pour dériver la première tension de bloc-batterie ;
• la deuxième unité de dérivation (200) est disposée entre la borne d'entrée de tension de bloc-batterie et le premier nœud (Q11) et connectée en parallèle avec la première unité de dérivation (100) pour dériver une deuxième tension de bloc-batterie ;
• l'unité de relais (300) est disposée entre le premier nœud (Q11) et un deuxième nœud (Q12) et est configurée pour commander la mesure de la tension de bloc-batterie selon une opération de commutation ; et
• l'unité de distribution de tension (400) est disposée entre le deuxième nœud (Q12) et la borne de masse, et est configurée pour diviser une tension de bloc-batterie fournie par le biais de la première (100) ou de la deuxième unité de dérivation (200) et de l'unité de relais (300) et ensuite pour délivrer en sortie la tension à une borne de sortie.

8. Circuit de mesure de tension de bloc-batterie selon la revendication 7, dans lequel la première unité de dérivation (100) comprend une deuxième résistance (R11) et un premier commutateur (S11) connectés en série entre la borne d'entrée de tension de bloc-batterie et le premier nœud (Q11).

9. Circuit de mesure de tension de bloc-batterie selon la revendication 8, dans lequel la deuxième unité de dérivation (200) comprend une troisième résistance (R12) et un deuxième commutateur (S12) connectés en série entre la borne d'entrée de tension de bloc-batterie et le premier nœud (Q11) et connectés en parallèle avec la deuxième résistance (R11) et le premier commutateur (S11), respectivement.

10. Circuit de mesure de tension de bloc-batterie selon la revendication 9, dans lequel le commutateur de relais (S13) et une première résistance (R13) sont connectés en parallèle entre le premier nœud (Q11) et le deuxième nœud (Q12).

11. Circuit de mesure de tension de bloc-batterie selon la revendication 10, dans lequel des valeurs de résistance de la première résistance (R11) et de la deuxième résistance (R12) sont différentes l'une de l'autre.
